# EUROPEAN PATENT SPECIFICATION

(11) **EP 4 381 300 B1**
(45) Date of publication and mention of the grant of the patent: **08.07.2026**
(21) Application number: 22768465.1
(22) Date of filing: 28.07.2022
(51) Int. Cl.: G01R 15/14, G01R 15/18, H01F 27/28, H01F 27/36, H01F 38/26, H01F 38/30

(54) **MEASURING DEVICE, APPARATUS FOR ELECTROTECHNICAL APPLICATIONS IN THE DOMAIN OF MEDIUM AND HIGH VOLTAGES AND METHOD FOR MAKING THE DEVICE**
MESSEINRICHTUNG, APPARAT FÜR ELEKTROTECHNISCHE ANWENDUNGEN IM BEREICH MITTEL- UND HOCHSPANNUNGEN SOWIE VERFAHREN ZUR HERSTELLUNG DER EINRICHTUNG
DISPOSITIF DE MESURE, APPAREIL POUR APPLICATIONS ÉLECTROTECHNIQUES DANS LE DOMAINE DES TENSIONS MOYENNES OU ÉLEVÉES ET PROCÉDÉ DE FABRICATION DU DISPOSITIF

(30) Priority: 05.08.2021 IT 202100021209
(43) Date of publication of application: 12.06.2024
(73) Proprietor: Electroceramica S.A., 401112 Turda (RO)
(72) Inventor: BARBERI, Marco, 13018 Valduggia (Vercelli) (IT)
(74) Representative: Tansini, Elio Fabrizio
(86) International application number: PCT/IB2022/056967
(87) International publication number: WO 2023/012609

(56) References cited:
- WO-A1-2005/103737
- WO-A1-2009/009878
- WO-A1-2012/070035
- US-A1- 2004 257 061
- US-A1- 2016 231 364

## Description

The present invention relates to a device, an apparatus for electrotechnical applications in the domain of medium and high voltages, and a method for making the device.

In particular, the present invention falls within the field of magnetic and electric field transducers for applications in the field of medium and high voltages. For example, the invention can be conveniently used to make LPITs (Low Power Integrated Transformer), e.g., inside carrier insulators, bushings, and/or terminations. In particular, the invention is usable for making carrier insulators and/or bushings identified herein as "active type", i.e., integrating systems for detecting and/or measuring desired parameters and physical quantities related to the current running through the conductors.

To date, such transducers are mainly made by means of Rogowski coils and resistive or capacitive dividers. Generally, such components are solid objects immersed or overmoulded in insulating material by means of APG (Automatic Pressure Gelation) process.

The same components are typically made in the form of conductive layers of continuous or reticular structure, such as planar structures facing electromagnetic field sources or cylindrical geometric structures, characterized by a greater accuracy in the extraction of signals proportional to the source and greater immunity with respect to external interferents.

Therefore, capacitive couplings, screens and/or baffles and/or electric field guides are made by means of solid or reticular layers, with planar or cylindrical geometry, in conductive material (such as copper, aluminium and brass alloys, and the like), or semi-conductive material (typically plastics and semiconductive elastomers). The reticular structures usually consist of woven nets, micro-stretched nets, or photo-etched conductive layers on flexible substrates.

The mesh size of such reticles determines the minimum tolerance in the sizing and creation of the conductive areas: as well as surface and peripheral discontinuities, truncated mesh would cause a concentration of load and thus an increase in electrical stress.

Achieving greater stability of the architecture in relation to possible inelastic deformations tends to require an increase in the thickness of the continuous or reticular stratifications. On the other hand, an increase in such thicknesses corresponds to a lesser compatibility of the structures with the co-moulding process, both due to the generation of thermal gradients and due to the action of the coefficients of thermal expansion, if different from those which are characteristic of the insulating material used.

Continuous structures or those with cylindrical geometry, as well as any windings for measuring the magnetic field, affect the orientation of the artefact during the overmoulding process, also in relation to the injection point of the equipment used, and can cause, together with the criticalities described in the previous points, structural stresses, detachments, cracks, lamination phenomena, failure to evacuate air bubbles or gaseous residues, causes of inhomogeneity also of the insulating material. Inhomogeneities in operating conditions in the domain of medium and high voltages can result in load concentrations and consequent deterioration of performance in productive and electrical terms, and early ageing of the artefact.

Overall, the known architectures have a significant footprint which results in a greater production criticality with regard to thermal gradients, detachments or laminations, chemical incompatibility between materials and any thermal expansion. A further problem of such transducers lies in their reduced application and lack of interchangeability. For example, integrating such transducers, active-type electrical insulators are not suitable for use in place of "passive-type" insulators, i.e., without a transducer, due to the larger size of the active insulator with respect to the passive insulator.

US 2004/0257061 A1 discloses a current sensor comprising surface coils embedded in circuit boards uniformly spaced around a central cavity adapted to receive the conductor through which the current to be measured flows.

Known arrangements for measuring the current flowing along an electrical conductor are also disclosed in US 2016/0231364 A1 and WO 2012/070035.

The technical task of the present invention is therefore to provide a device, an apparatus for electrotechnical applications in the domain of medium and high voltages and a method for making the device which are able to overcome the drawbacks resulting from the prior art.

The object of the present invention is therefore to provide a device, an apparatus for electrotechnical applications in the domain of medium and high voltages and a method for making the device which allow to obtain a structure transparent to the overmoulding process and to the equipment involved.

A further object of the present invention is therefore to provide a device, an apparatus for electrotechnical applications in the domain of medium and high voltages and a method for making the device which exhibit a higher order accuracy preferably with a smaller footprint with respect to the devices of the prior art.

The specified technical task and the specified objects are substantially achieved by a device, an apparatus for electrotechnical applications in the domain of medium and high voltages and a method for making the device comprising the technical features set out in one or more of the appended claims. The dependent claims correspond to possible embodiments of the invention.

In particular, the specified technical task and the specified objects are achieved by a device for measuring physical quantities of an electrical conductor, according to claim 1. The device provides radial boards, each comprising a plurality of conductive layers parallel to each other. Each conductive layer comprises a first portion comprising at least one conductive track defining a zero potential area with a screen function, extending parallel to a geometric axis of reference. The zero potential area delimits, radially outwards, a shadow zone which is distal to the geometric axis of reference, in which a second portion of the layer operates, comprising one or more spiral conductive tracks with magnetic field transducer function.

The radial board further comprises a series of electrically conductive inserts, typically referred to as "pathways", which allow an orthogonal electrical connection between the parallel conductive layers passing at least through the zero potential area.

The parallel conductive planes interconnected with the orthogonal connection pathways, assume the desired functions as a result of how they are connected. If referred to zero potential, they work as a screen or deflector, if floating, i.e., not connected to reference potentials, they are capacitively coupled to the nearby electric field.

Preferably, at least two of said spiral conductive tracks are provided in each conductive layer, respectively side by side.

The spiral conductive tracks are preferably symmetrical with respect to a radial plane to the geometric axis of reference.

Preferably, the connection pathways are defined by metallized cylinders appropriately distributed along said zero potential area and/or by metallized edges made in an opening defining said zero potential area. Preferably, each spiral conductive track is defined by a quadrangular or round spiral-shaped metallization.

Preferably, said first portion further comprises one or more conductive tracks defining respective auxiliary areas with a field deflector function and/or with a voltage detection function.

Preferably, the auxiliary areas extend parallel to said zero potential area. Preferably, said zero potential area is interposed between said auxiliary areas and said spiral conductive tracks.

Preferably, the zero potential area is interposed between the shadow zone and the geometric axis of reference.

Preferably, the geometric axis of reference is parallel to the extension axis of the electrical conductor.

Preferably, the geometric axis of reference coincides with the extension axis of the electrical conductor.

Preferably, the first portion has an axial extension dimension, parallel to the geometric axis of reference, greater than an axial extension dimension of the second portion.

Preferably, said first portion further comprises at least one conductive track defining an additional area, configured to define a capacitive coupling with said electrical conductor, said zero potential area being interposed between said additional area and said spiral conductive tracks. Preferably, said additional area is aligned and interposed between two of said auxiliary areas.

Preferably, said one or more auxiliary areas and/or said additional area are each defined by an opening provided with at least one metallized edge.

Preferably, the connection pathways are also appropriately distributed between said one or more auxiliary areas and/or said additional area. Preferably, a temperature sensor is included which is arranged in said shadow zone defined by the zero potential area.

Preferably, said second portion has an assembly recess, arranged between said spiral conductive tracks.

Preferably, each conductive layer comprises radial conductive tracks referring to terminals arranged near a peripheral edge of the second portion.

Preferably, the radial conductive tracks connect at least one of said zero potential areas, auxiliary areas and additional area with said terminals. Preferably, the terminals are arranged at said assembly recess.

Preferably, the conductor ring comprises a zero potential area with screen function defined along a circumferential extension of the conductor ring. Preferably, said conductor ring comprises a plurality of through openings. Preferably, the zero potential area with screen function is defined along an inner edge and/or along an outer edge of said conductor ring.

Preferably, the conductor ring is made by means of a multilayer structure. Preferably, the multilayer structure comprises at least two insulating inner layers provided with connection tracks in conductive material.

Preferably, the multilayer structure comprises two outer layers of conductive material referring to zero potential.

Preferably, the outer layers integrate a Faraday cage containing the inner layers.

Preferably, the multilayer structure is crossed by conductive pathways. Preferably, the conductive pathways are distributed according to at least one circumference along at least one of the radially inner and radially outer edges of the conductor ring.

Preferably, the conductive pathways are distributed according to two concentric circumferences, respectively along a radially inner edge and a radially outer edge of the conductor ring.

Preferably, each of the conductive pathways has a cylindrical tubular structure.

Furthermore, the specified technical task and the specified objects are substantially achieved by an apparatus for electrotechnical applications in the domain of medium and high voltages comprising a main body made of electrically insulating material, an electrical conductor at least partially embedded in the main body and extending along an extension axis thereof, a device as described above embedded in the main body and arranged around said electrical conductor, and a connector for connecting said device to a control terminal.

Preferably, with each capacitive coupling of the device, the connector defines a capacitive voltage divider.

Preferably, a top portion and a bottom portion of the main body define a through bar.

Preferably, anchoring inserts are included which are carried by the conductor ring of the device.

Preferably, the anchoring inserts are at least partially embedded in the main body.

Preferably, the anchoring inserts are configured for fastening the apparatus to a containment cabin of a transformer or other support structure.

Preferably, the anchoring inserts are configured for the zero potential connection of the device.

Preferably, the main body is made of epoxy resin.

Furthermore, the technical task specified and the objects specified are substantially achieved by a method for making an apparatus as described above comprising the steps of providing an electrical conductor, providing a device as described above, arranging the electrical conductor inside the device, embedding the device and at least part of the electrical conductor with an insulating material.

Preferably, the step of arranging the electrical conductor includes positioning the electrical conductor coaxially to the device.

Preferably, the embedding in the insulating material includes the steps of providing a mould defining a moulding cavity counter-shaped to the main body, and placing the electrical conductor and the device inside the mould. Preferably, the device is fastened inside the moulding cavity at said anchoring inserts.

Preferably, the anchoring inserts are engaged in respective seats arranged in the moulding cavity.

Preferably, it is further included to inject the insulating material through at least one injection opening of the insulating material, confluent in the moulding cavity according to a direction substantially parallel to the extension axis of the conductor.

Preferably, the moulding step is obtained by means of APG process. Further features and advantages of the present invention will become more apparent from the description of an exemplary, and therefore nonlimiting, embodiment of a radial board, a device, an apparatus for electrotechnical applications in the domain of medium and high voltages, and a method for making the apparatus.

Such a description will be set out hereinafter with reference to the accompanying drawings given only for illustrative and, therefore, nonlimiting purpose, in which:
- Figure 1 is a schematic representation of an exploded view of the radial board which forms the object of the present invention;
- Figure 2 is a schematic representation of a perspective view of a device which forms the object of the present invention;
- Figure 3 is a schematic representation of a perspective view of the device which forms the object of the present invention;
- Figure 4 is a schematic representation of an exploded view of a component of the device of figure 2.

With reference to the accompanying drawings, the number 1 globally indicates a radial board for measuring the physical quantities of an electrical conductor "E".

The electrical conductor "E" generates magnetic field lines which are concentric to each other, with respect to an extension axis "A" of the electrical conductor "E", and radial electric field lines with respect to the aforesaid extension axis "A".

The radial board 1 comprises a plurality of conductive layers 1a coupled in parallel. Each conductive layer 1a comprises a substrate in electrically insulating material, typically fibreglass for example of the type identified by the classification FR4, on at least one face of which several conductive tracks are made, for example by means of photoengraving or other techniques usually used in the creation of printed circuits. Depending on their positioning and their circuit connection with other parts, such conductive tracks define respective functional areas which will be better identified and described later. Therefore, each of the areas described below corresponds to at least one respective conductive track.

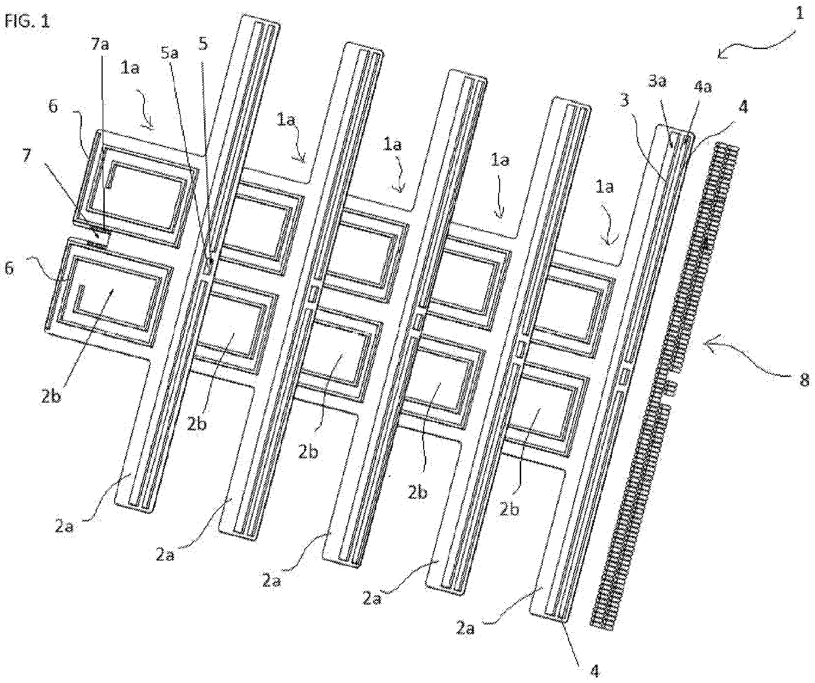

Preferably, each radial board 1 comprises at least two parallel conductive layers 1a. Figure 1 depicts a radial board 1 comprising five conductive layers 1a.

Each conductive layer 1a comprises a first portion 2a comprising a zero potential area 3 with a screen function, extending parallel to a geometric axis of reference. The zero potential area 3 delimits, with respect to the electromagnetic field lines generated by the passage of current along the electrical conductor "E", a shadow area which is distal from the geometric axis of reference. In other words, the zero potential area 3 is interposed between the shadow zone and the electrical conductor "E".

Each zero potential area 3 ends without protruding from the respective layer 1a and/or board 1, so as to avoid the generation of tips or protrusions which would facilitate undesired load concentration phenomena.

Preferably, the geometric axis of reference is parallel to the extension axis "A" of the electrical conductor "E".

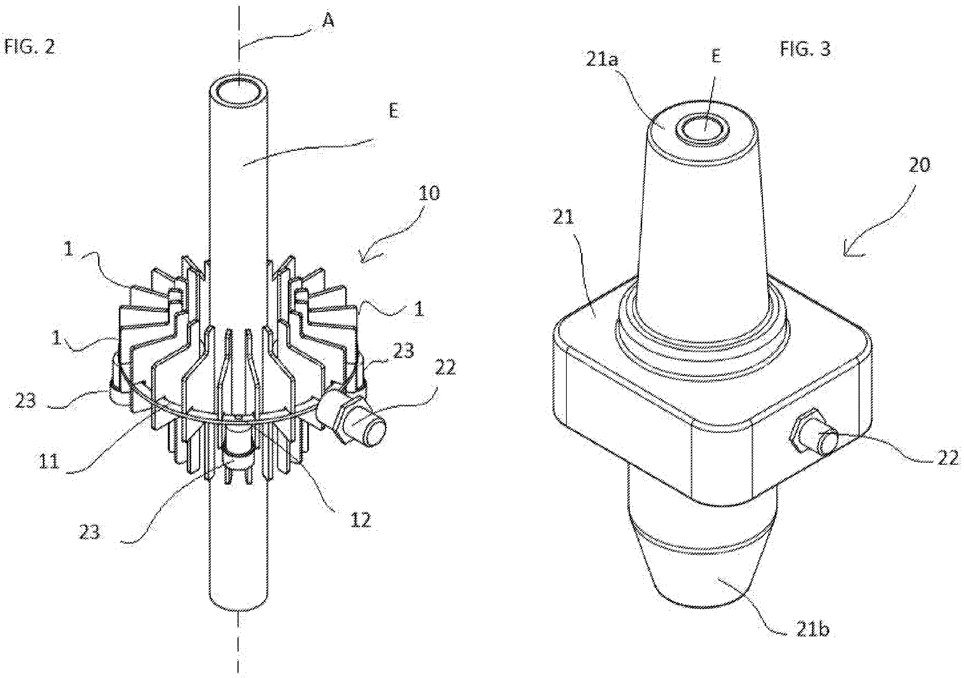

Even more preferably, the geometric axis of reference coincides with the extension axis "A" as shown, for example, in figure 2.

In other words, the radial board 1 extends so that the first portion 2a is always facing the geometric axis of reference, i.e., towards the extension axis "A", as better seen in figure 2. Preferably, at least the first portion 2a is tangent to the equipotential lines generated by the electrical conductor "E", and extends parallel to the extension axis "A".

Preferably, as for example shown in figure 1, the zero potential area 3 of each conductive layer 1a is defined along an edge of a through opening 3a, obtained through the same conductive layer 1a. The through openings 3a of the various conductive layers 1a are arranged in collimation with respect to one another so as to define as a whole a single continuous passage which integrally crosses the respective radial board 1 in its entire thickness.

The zero potential area 3 is therefore arranged in a position tangent to one or more equipotential lines of the electric field generated by the electrical conductor "E" extending along the extension axis "A".

Preferably, the first portion 2a of each conductive layer 1a can further comprise one or more auxiliary areas 4, two in the illustrated example, which respectively integrate or implement a field deflector and/or a voltage detector.

Preferably, the first portion 2a further comprises at least one additional area 5 configured to define or implement a capacitive coupling with the electrical conductor "E".

The auxiliary areas 4 and the additional area 5 are arranged parallel to the zero potential area 3 so as to be radially interposed, in use, between the electrical conductor "E" and the zero potential area 3.

Similar to what has been said for the zero potential area 3, the auxiliary areas 4 and the additional area 5 can be defined along the edges of respective through openings 4a, 5a obtained through the conductive layers 1a. The edges of the through openings 4a, 5a belonging to the various conductive layers 1a are superimposed in mutual collimation, so as to form continuous passages through the entire thickness of the radial board 1.

With regard to the auxiliary areas 4, the field deflector function is obtainable by referring the same to zero potential, i.e., by connecting them to zero potential, while a connection thereof to an indicator, for example of the luminous type, can be used to achieve the voltage detection function. The voltage detection function of one or more of the auxiliary areas 4 can also be obtained so that there is simultaneously the field deflector function. Alternatively, some of the auxiliary areas 4 can be connected to zero potential to perform the function of field deflector, while others are entrusted with the function of voltage detection only.

The auxiliary areas 4 are therefore defined in order to screen, deflect, and/or guide interfering electric field lines with respect to the additional areas 5 and/or other conductive areas exposed to the field lines generated by the electrical conductor "E".

The additional area 5, axially interposed between the auxiliary areas 4, can be conveniently used to power a voltage meter (not shown), or otherwise aimed at obtaining a transducer of the electric field produced by the electrical conductor "E".

In other words, while the additional central area 5, capacitively coupled with the electrical conductor "E", performs the function of detecting voltage and/or other electrical parameters inside the conductor itself, the auxiliary areas 4 can conveniently work as field deflectors to remove interfering sources which could contaminate the accuracy of the measurement. The particular positioning of the additional area 5 defining the capacitive coupling optimizes the immunity to the aforesaid interfering sources. In fact, several capacitive-type couplings are substantially used in which a small central area (with respect to the other two) acts as a field detector while the other two act as field deflectors, distancing the aforesaid interfering sources and increasing the accuracy of the reading by the central area.

Each conductive layer 1a further comprises a second portion 2b defining a single body with the first portion 2a and located in a position which is distal with respect to the geometric axis of reference. Therefore, the second portion 2b, arranged according to a substantially radial orientation with respect to the electrical conductor "E" and/or the geometric axis of reference operates in the shadow zone defined by the zero potential area, and comprises at least one spiral conductive track 6. In the preferential example shown, two spiral conductive tracks 6 are included, symmetrically side by side along the axial extension dimension, having magnetic field transducer function.

In particular, the spiral conductive tracks 6 of each conductive layer 1a define a discretization of the magnetic field transducer. The term discretization is intended to mean that each spiral conductive track 6 defines part of a continuous coil. In this regard, the spiral conductive tracks 6 are conveniently connected to each other so that they can behave as a series of coils, for example of the Rogowski type.

In other words, the second portion 2b of the multilayer radial board 1 defines a magnetic field transducer generated by the electrical conductor "E". The second portion 2b can also serve as a screen for the interfering sources from outside the architecture.

As depicted in figure 1, the zero potential area 3 is interposed between the spiral conductive tracks 6 and the auxiliary 4 and additional 5 areas.

The zero potential area 3, referring to zero potential, acts as a screen against the electric fields generated by the conductor "E" and other neighbouring sources, while being permeable to the magnetic fields Each of the spiral conductive tracks 6 can be made in the form of a quadrangular or round spiral.

Preferably, an assembly recess 7 is obtained in the second portion 2b, arranged between the spiral conductive tracks 6.

The radial board 1 further comprises a series of conductive inserts or bridges, hereinafter referred to as the connection pathway and collectively indicated in figure 1 with the number 8, extending through the conductive layers 1a at least at the zero potential areas 3, so as to electrically connect the conductive tracks present in each of the conductive layers 1 to each other. In a preferential embodiment, connection pathways 8 area also included at the auxiliary areas 4 and/or the additional area 5.

The connection pathways 8 can be made in the form of elongated bodies perpendicular to the conductive layers 1a. In other words, the connection pathways 8 can be defined as inserts or rivets, cylindrical or tubular, made of conductive material, and/or in the form of a conductive coating deposited on the inner walls of the through openings 3a and/or 4a, and/or 5a. In a preferential embodiment, the connection pathways 8 have a tubular shape and integrally pass through each conductive layer 1a. thus favouring the passage of resin between the conductive layers 1a.

In at least one of the zero potential 3, auxiliary 4 and/or additional 5 areas, a plurality of connection pathways 8 are preferably arranged consecutively side by side with each other in an axial direction, so as to strengthen the effectiveness of the screen, field deflector and/or capacitive coupling functions entrusted to each of the areas themselves.

The spiral conductive tracks 6 can also conveniently be connected to each other by means of connection pathways, not shown in the accompanying drawings. Being placed in a radially outer position with respect to the zero potential area 3, the spiral conductive tracks 6 work in a shadow zone, thus in a condition of immunity with respect to the electrical interference generated by the electrical conductor "E".

Preferably, the first portion 2a has an axial extension dimension, detectable parallel to the geometric axis of reference, greater than an axial extension dimension of the second portion 2b. In other words, the first portion 2a has a main extension dimension which is more elongated with respect to a main extension dimension of the second portion 2b. Thereby, the second portion 2b is more screened from the interferences generated by the electrical conductor "E". Overall, as depicted in the accompanying drawings, each conductive layer 1a, as well as each radial board 1, has a substantially T-shape.

In the radial board 1, at least one temperature sensor can be conveniently installed near the second portion 2b, i.e., in the shadow zone defined by the zero potential area 3. Such a temperature sensor can be of the PTC (Positive Temperature Coefficient) or NTC (Negative Temperature Coefficient) type.

Preferably, each conductive layer 1a further comprises radial conductive tracks, not depicted in the drawings, referring to respective terminals 7a arranged near a peripheral edge of the second portion 2b, preferably at the assembly recess 7, for connecting the terminals themselves to the zero potential 3, auxiliary 4 and/or additional areas 5 and/or to the respective circuit elements arranged in the first portion 2a and the second portion 2b. One or more of these radial conductive tracks can be conveniently arranged in at least one of the conductive layers 1 to place in electrical continuity at least one of the auxiliary areas 4 and/or the additional area 5 capacitively coupled to the electric field lines generated by the electrical conductor "E", to a user device outside the radial board 1, so as to extract the signal from the critical area between the electrical conductor "E" and the additional area 5, without the use of additional elements such as welds, signal cables, screws or rivets, the presence of which could compromise the electrical performance and/or distribution of the electric field lines.

Figure 2 shows a device 10 for measuring the physical quantities of the electrical conductor "E".

The device 10 comprises a plurality of radial boards 1 as described above and distributed around the geometric axis of reference, preferably parallel and/or coincident with the extension axis "A" of the electrical conductor "E".

Preferably, the radially inner ends of the boards 1, i.e., of the first portions 2a, are mutually approached at a mutual distance of a few mm, preferably less than 4 mm, so that the set of zero potential areas 3 can emulate the behaviour of the traditional screens obtained by means of a reticular structure.

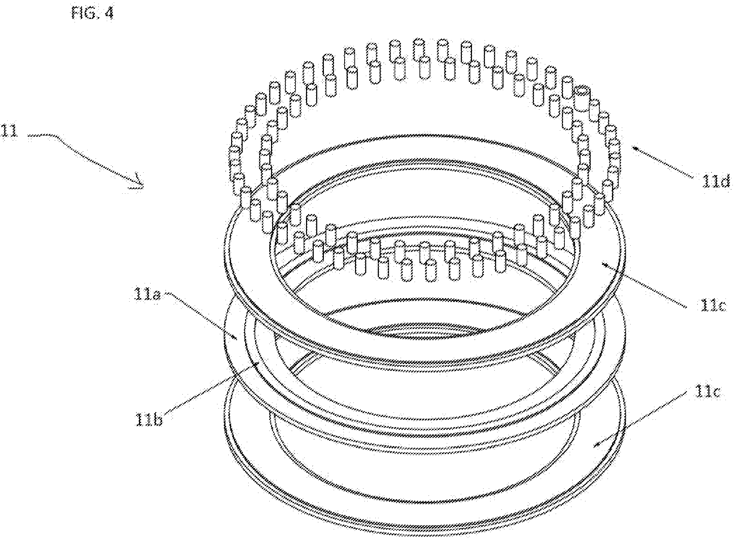

The possibility of positioning the boards 1 at an approached distance with respect to the geometric axis of reference also allows the additional areas 5 and/or other conductive parts to be inside an area with so-called "near field" features, where the reading of the electrical parameters can be carried out in the absence of perturbations and thus with greater precision. The device 10 further comprises a conductor ring 11, schematically depicted in figure 4, connected or connectable to the second portion 2b of each radial board 1 by means of the terminals 7a.

Similar to what has been said for each of the radial boards 1, the conductor ring 11 has a multilayer structure comprising two outer layers 11c, between which are axially interposed one or more inner layers 11a, preferably at least two inner layers 11a, comprising respective conductive connection tracks 11b.

Each of the conductive connection tracks 11b of the inner layers is interconnected, at the terminals 7a of each board, to the respective spiral conductive tracks 6, additional area 5 and/or at least one of the auxiliary areas 4. The spiral conductive tracks 6, the additional areas 5 and/or at least one of the auxiliary areas 4 of each radial board 1 are thus respectively connected with the spiral conductive tracks 6, the additional areas 5 and/or corresponding auxiliary areas 4 of all the other radial boards 1, by means of one or more of the conductive connection tracks 11b carried by the conductor ring 11. The cooperation of the homologous parts of the different boards respectively connected to each other, achieves the effects of components such as screens, field deflectors, capacitive and/or magnetic couplings, virtually continuous, even if consisting of discrete elements integrated in the individual radial boards 1. The conductor ring 11 further comprises at least one circumferential zero potential area with a screen function defined along a circumferential extension of the conductor ring itself. Such a zero potential area can be defined by at least one conductive coating carried by one of the outer layers 11c, preferably by both, and electrically connected to zero potential outside the device 10. Through the respective terminals 7a, the conductive coatings of the outer layers 11c are connected to the zero potential areas 3 and to at least one of the auxiliary areas 4 of each radial board 1, connecting them to each other.

The circumferential zero potential area can also be implemented by conductive pathways 11d integrally crossing the outer and inner layers.

Such conductive pathways 11d can be distributed according to at least one, preferably two concentric circumferences, respectively along a radially inner edge and a radially outer edge of the conductor ring 11. The assembly formed by the conductive coatings and the conductive pathways 11d, all in a mutual galvanic connection relationship, causes the outer layers to define a Faraday cage containing the inner layers 11a, inside which the connection tracks 11b are enclosed and conveniently protected from external interference.

The conductive pathways 11d can conveniently have a cylindrical tubular structure, so as to create respective channels through the thickness of the conductor ring 11. Further through openings, if required, can be obtained directly through the inner 11a and outer layers 11c.

The connections with the terminals 7a can be obtained by welding or other mechanical locking systems, so as to also determine a structural stabilization of the radial boards 1 engaged with the conductor ring 11.

The conductive connection tracks 12b as well as the conductive coatings of the outer layers 11c can be connected to at least one connector 22 protruding peripherally with respect to the conductor ring 11, usable for connecting the device 10 to a control terminal.

The conductor ring 11 or other portion of the device 10 can also be associated with one or more anchoring inserts 23 which allow the mechanical fastening, for example, to the containment cabin of a transformer or other enclosure or support structure, for the mechanical anchoring of the device 10 and/or the connection to zero potential thereof. In the example shown, four circumferentially-distributed anchoring inserts 23 are included.

Figure 3 schematically depicts an apparatus 20 for electrotechnical applications in the domain of medium and high voltages comprising a main body 21 made for example by means of epoxy resin or other electrically insulating material, an electrical conductor "E" at least partially embedded in the main body 21 and extending along a main extension axis "A", a device 10 as described above embedded in the main body 21 and arranged around the electrical conductor "E" (as shown in figure 2).

As depicted in the accompanying drawings, the device 10 is arranged coaxially with the electrical conductor "E".

In the illustrated example, the apparatus 20 is adapted to make a so-called through bushing insulator, which can be installed through a special hole arranged in the wall of a cabin of a transformer, or other support structure, to allow the passage of the electrified line through the cabin itself. In the main body 21, an upper portion 21a and a lower portion 21b can be identified, which, once installed, will protrude respectively towards the outside and towards the inside of the cabin. The anchoring inserts 23 are used for fastening the apparatus 20 to the cabin and its connection to zero potential through the latter.

In a three-phase line, at least three bushing insulators are typically used, one for each of the phases, the dimensions of which condition the minimum distance at which respective electrical conductors can be installed.

The apparatus 20 described above is suitable to be conveniently made in accordance with a method forming a further aspect of the present invention.

The method comprises the steps of providing an electrical conductor "E", providing a device 10 and arranging the electrical conductor "E" inside the device 10.

Preferably, the step of arranging the electrical conductor "E" includes arranging the electrical conductor "E" coaxially with the device 10.

It is also envisaged to embed the device 10 and at least part of the electrical conductor "E" in a main body in epoxy resin or other insulating material.

The embedding in the insulating material includes the steps of providing a mould defining a moulding cavity counter-shaped to the main body 21, and placing the electrical conductor "E" and the device 10 inside the mould.

The anchoring inserts 23 can be conveniently used to obtain an adequate fastening of the device 10 inside the moulding cavity, equipped with special seats for engaging the inserts themselves. At least one injection opening of the insulating material converges in the moulding cavity, oriented according to a direction substantially parallel to the extension axis "A" of the conductor "E".

At this point, in order to achieve the embedding of the device 10 and at least part of the electrical conductor "E", the moulding step includes injecting the insulating material through the injection opening along a filling direction of the mould substantially parallel to the extension axis "A" of the electrical conductor "E". The filling direction can be inclined by some degrees to facilitate the evacuation of air and improve the homogeneity of the insulating material. Preferably, the moulding step is accomplished by means of APG (Automatic Pressure Gelation) process.

The orientation of the boards 1 according to respective radial planes to the extension axis "A" facilitates the sliding of the insulating material inside the mould, so as to facilitate a correct filling of the moulding cavity without inducing deformations or abnormal stresses in the components of the device 10. The presence of the through openings and the channels offered by the tubular conductive pathways 11d facilitates the sliding of the insulating material through the conductor ring 11, facilitating the outflow and the incorporation of the same ring despite the orientation of the latter according to a plane transverse to the injection direction. The further through openings 3a, 4a, 5a obtained through the individual radial boards 1 offer a further contribution to a correct distribution of the insulating material during the filling of the moulding cavity, and to the subsequent anchoring of the device 10 inside the main body 21. The structural consistency and the limited thermal expansion expressed by the materials - mainly fibreglass or the like - used to make the radial boards and the conductor ring 11 allows to limit the geometric and dimensional variations induced as a result of the thermal oscillations induced during the overmoulding process within negligible values, so as to favour a high dimensional stability even in the case of mechanical, electrical and thermal stress, low degradation over time, and a high control and repeatability of the production process. The integration of the circuit elements in the radial boards favours the absence of significant surface and peripheral discontinuities for the overmoulding process, negligible thermal gradients with respect to the same overmoulding process and negligible peripheral electrical stress in the operating condition in the domain of medium and high voltages.

Advantageously, the present invention allows to obtain higher order accuracy classes in the creation of magnetic and electric field transducers with respect to the prior art. In fact, the structural stability of the system allows to obtain greater geometric and dimensional precision of the components, which is why it is possible to place the capacitive coupling elements closer to the electrical conductor "E" with respect to the prior art, and this leads to a greater sensitivity and precision in the detection of electrical quantities.

A greater approximation of the radial boards 1 to the electrical conductor "E" also corresponds to a significant reduction in the overall dimensions of the apparatus 20. This circumstance allows the installation of several devices 20 also maintaining, in three-phase systems for medium voltage, a distance between the conductors "E" at reduced values, even of the order of 100 mm or less, currently usable only with "passive" type insulators. The apparatus 20 is therefore also suitable for use in place of passive devices, to implement an existing system through the installation of active bushing devices, capable of detecting the electrical parameters of the flowing currents through the electrical conductors "E".

## Claims

1. Device (10) for measuring physical quantities of an electric conductor (E), comprising a plurality of radial boards (1), each for measuring said physical quantities
wherein the radial boards are distributed around a geometric axis of reference,
**characterized in that** each radial board comprises a plurality of parallel conductive layers (1a), each conductive layer (1a) comprising:
- a first portion (2a) comprising a zero potential area (3) with a screen function, extending parallel to said geometric axis of reference, and defining a shadow zone which is distal with respect to said geometric axis of reference;
- a second portion (2b) comprising one or more spiral conductive tracks (6) with magnetic field transducer function, said second portion (2b) operating in said shadow zone;
said radial board (1) further comprising a series of connection pathways (8) between the conductive layers (1a) passing at least through said zero potential area (3), and
wherein the device further comprises a conductor ring (11) connected or connectable to the second portion (2b) of each radial board (1) by means of interconnecting elements.

2. Device according to one or more of the preceding claims, wherein said first portion (2a) further comprises one or more auxiliary areas (4) with a field deflector function and/or with a voltage detection function extending parallel with said zero potential area (3), said zero potential area (3) being interposed between said auxiliary areas (4) and said spiral conductive tracks (6).

3. Device according to one or more of the preceding claims, wherein said first portion (2a) further comprises at least one additional area (5), configured to define a capacitive coupling with said electric conductor (E), said zero potential area (3) being interposed between said additional area (5) and said spiral conductive tracks (6).

4. Device according to claim 2 and 3, wherein said additional area (5) is aligned and interposed between two of said auxiliary areas (4).

5. Device according to one or more of claims 2-4, wherein said connection pathways (8) are also appropriately distributed between said one or more auxiliary areas (4) and/or said additional area (5).

6. Device according to one or more of the preceding claims, comprising a temperature sensor arranged in said shadow zone defined by the zero potential area (3).

7. Device according to one or more of the preceding claims, wherein said second portion (2b) has an assembly recess (7), arranged between said spiral conductive tracks (6).

8. Device according to claim 7, wherein each conductive layer (1a) comprises radial conductive tracks referring to terminals arranged near a peripheral edge of the second portion (2b).

9. Device according to one or more of the preceding claims, wherein said conductor ring (11) comprises a zero potential area defined along a circumferential extension of said conductor ring (11).

10. Device (10) according to one or more of the preceding claims, wherein said conductor ring (11) is made by means of a multilayer structure comprising one or more inner layers (11a) provided with connection tracks (11b) and two outer layers (11c) referring to zero potential.

11. Device (10) according to claim 10, wherein the outer layers (11c) integrate a Faraday cage containing the inner layers (11a).

12. Device (10) according to claim 10 or 11, wherein the multilayer structure of the conductor ring (11) is crossed by conductive pathways (11d) distributed according to concentric circumferences, respectively along a radially inner edge and a radially outer edge of the conductor ring (11).

13. Apparatus (20) for electrotechnical applications in the domain of medium and high voltages comprising a main body (21) made of electrically insulating material, an electric conductor € at least partially embedded in the main body and extending along an extension axis (A) thereof, a device (10) according to one or more of the preceding claims embedded in the main body (21) and arranged around said electric conductor (E), and a connector (22) for connecting said device (10) to a control terminal.

14. Method for making an apparatus (20) according to claim 13, comprising the steps of:
- providing an electrical conductor (E);
- providing a device (10) according to one or more of claims 1 - 12;
- arranging said electrical conductor (E) inside said device (10);
- embedding said device (10) and at least part of said electrical conductor (E) with an insulating material.

15. Method according to claim 14, wherein the embedding in insulating material includes:
- providing a mould defining at least one moulding cavity counter-shaped to the main body;
- placing the electrical conductor and the device inside the mould;
- fastening the device inside the moulding cavity at anchoring inserts (23) carried by the conductor ring (11);
- injecting the insulating material through at least one injection opening of the insulating material, confluent in the moulding cavity according to a direction substantially parallel to the extension axis (A) of the conductor (E).

## Patentansprüche

1. Einrichtung (10) zum Messen physikalischer Größen eines elektrischen Leiters (E), umfassend eine Vielzahl radialer Platten (1), die jeweils zum Messen der genannten physikalischen Größen dienen,
wobei die radialen Platten um eine geometrische Bezugsachse verteilt sind, **dadurch gekennzeichnet, dass** jede radiale Platte eine Vielzahl paralleler leitfähiger Schichten (1a) umfasst, wobei jede leitfähige Schicht (1a) Folgendes umfasst:
- einen ersten Abschnitt (2a), der einen Nullpotentialbereich (3) mit Abschirmfunktion umfasst, parallel zu der genannten geometrischen Bezugsachse verläuft und eine Schattenzone definiert, die in Bezug auf die genannte geometrische Bezugsachse distal liegt;
- einen zweiten Abschnitt (2b), der eine oder mehrere spiralförmige Leiterbahnen (6) mit Magnetfeldwandlerfunktion umfasst, wobei der genannte zweite Abschnitt (2b) in der genannten Schattenzone arbeitet;
wobei die genannte radiale Platte (1) eine Reihe von Verbindungswegen (8) zwischen den leitfähigen Schichten (1a) weiter umfasst, die mindestens durch den genannten Nullpotentialbereich (3) verlaufen, und
wobei die Einrichtung einen Leiterring (11) weiter umfasst, der mittels Verbindungselementen mit dem zweiten Abschnitt (2b) jeder radialen Platte (1) verbunden oder verbindbar ist.

2. Einrichtung nach einem oder mehreren der vorangegangenen Ansprüche, wobei der genannte erste Abschnitt (2a) einen oder mehrere Hilfsbereiche (4) mit Feldablenkungsfunktion und/oder mit Spannungserfassungsfunktion weiter umfasst, die parallel zu dem genannten Nullpotentialbereich (3) verlaufen, wobei der genannte Nullpotentialbereich (3) zwischen den genannten Hilfsbereichen (4) und den genannten spiralförmigen Leiterbahnen (6) eingefügt ist.

3. Einrichtung nach einem oder mehreren der vorangegangenen Ansprüche, wobei der genannte erste Abschnitt (2a) mindestens einen zusätzlichen Bereich (5) weiter umfasst, der darauf ausgelegt ist, eine kapazitive Kopplung mit dem genannten elektrischen Leiter (E) zu definieren, wobei der genannte Nullpotentialbereich (3) zwischen dem genannten zusätzlichen Bereich (5) und den genannten spiralförmigen Leiterbahnen (6) eingefügt ist.

4. Einrichtung nach Anspruch 2 und 3, wobei der genannte zusätzliche Bereich (5) zwischen zwei der genannten Hilfsbereiche (4) ausgerichtet und eingefügt ist.

5. Einrichtung nach einem oder mehreren der Ansprüche 2 bis 4, wobei die genannten Verbindungswege (8) ebenfalls in geeigneter Weise zwischen dem genannten einen oder den genannten mehreren Hilfsbereichen (4) und/oder dem genannten zusätzlichen Bereich (5) verteilt sind.

6. Einrichtung nach einem oder mehreren der vorangegangenen Ansprüche, umfassend einen Temperatursensor, der in der durch den Nullpotentialbereich (3) definierten genannten Schattenzone angeordnet ist.

7. Einrichtung nach einem oder mehreren der vorangegangenen Ansprüche, wobei der genannte zweite Abschnitt (2b) eine Montageaussparung (7) aufweist, die zwischen den genannten spiralförmigen Leiterbahnen (6) angeordnet ist.

8. Einrichtung nach Anspruch 7, wobei jede leitfähige Schicht (1a) radiale Leiterbahnen umfasst, die zu in der Nähe einer Außenkante des zweiten Abschnitts (2b) angeordneten Anschlüssen führen.

9. Einrichtung nach einem oder mehreren der vorangegangenen Ansprüche, wobei der genannte Leiterring (11) einen Nullpotentialbereich umfasst, der entlang eines Umfangsverlaufs des genannten Leiterrings (11) definiert ist.

10. Einrichtung (10) nach einem oder mehreren der vorangegangenen Ansprüche, wobei der genannte Leiterring (11) mittels einer Mehrschichtstruktur gebildet wird, die eine oder mehrere innere Schichten (11a) mit Anschlussbahnen (11b) und zwei auf Nullpotential bezogene äußere Schichten (11c) umfasst.

11. Einrichtung (10) nach Anspruch 10, wobei die äußeren Schichten (11c) einen Faradayschen Käfig bilden, der die inneren Schichten (11a) enthält.

12. Einrichtung (10) nach Anspruch 10 oder 11, wobei die Mehrschichtstruktur des Leiterrings (11) von Leitwegen (11d) überquert wird, die konzentrischen Umfängen folgend jeweils entlang eines radial inneren Randes und eines radial äußeren Randes des Leiterrings (11) verteilt sind.

13. Apparat (20) für elektrotechnische Anwendungen im Bereich Mittel- und Hochspannungen, umfassend einen Hauptkörper (21) aus elektrisch isolierendem Material, einen elektrischen Leiter (E), der mindestens teilweise in den Hauptkörper eingebettet ist und entlang einer Verlaufsachse (A) desselben verläuft, eine Einrichtung (10) nach einem oder mehreren der vorangegangenen Ansprüche, die in den Hauptkörper (21) eingebettet und um den genannten elektrischen Leiter (E) herum angeordnet ist, sowie einen Verbinder (22) zum Anschließen der genannten Einrichtung (10) an ein Steuergerät.

14. Verfahren zur Herstellung eines Apparats (20) nach Anspruch 13, umfassend die folgenden Schritte:
- Bereitstellen eines elektrischen Leiters (E);
- Bereitstellen einer Einrichtung (10) nach einem oder mehreren der Ansprüche 1 bis 12;
- Anordnen des genannten elektrischen Leiters (E) im Inneren der genannten Einrichtung (10);
- Einbetten der genannten Einrichtung (10) und mindestens eines Teils des genannten elektrischen Leiters (E) in ein Isoliermaterial.

15. Verfahren nach Anspruch 14, wobei das Einbetten in Isoliermaterial Folgendes einschließt:
- Bereitstellen einer Form, die mindestens einen ein Gegenprofil zum Hauptkörper bildenden Formhohlraum definiert;
- Platzieren des elektrischen Leiters und der Einrichtung im Inneren der Form;
- Befestigen der Einrichtung im Inneren des Formhohlraums an vom Leiterring (11) getragenen Verankerungseinsätzen (23);
- Einspritzen des Isoliermaterials durch mindestens eine Einspritzöffnung für Isoliermaterial, die in den Formhohlraum mündet, entlang einer Richtung, die im Wesentlichen parallel zur Verlaufsachse (A) des Leiters (E) ist.

## Revendications

1. Dispositif (10) de mesure de grandeurs physiques d'un conducteur électrique (E), comprenant une pluralité de cartes radiales (1), chacune étant destinée à mesurer lesdites grandeurs physiques
où les cartes radiales sont réparties autour d'un axe géométrique de référence,
**caractérisé en ce que** chaque carte radiale comprend une pluralité de couches conductrices parallèles (1a), chaque couche conductrice (1a) comprenant :
- une première partie (2a) comprenant une zone à potentiel nul (3) à fonction d'écran, s'étendant parallèlement audit axe géométrique de référence, et définissant une zone d'ombre distale par rapport audit axe géométrique de référence ;
- une deuxième partie (2b) comprenant une ou plusieurs pistes conductrices en spirale (6) à fonction de transducteur de champs magnétiques, ladite deuxième partie (2b) fonctionnant dans ladite zone d'ombre ;
ladite carte radiale (1) comprenant en outre une série de voies de connexion (8) entre les couches conductrices (1a) traversant au moins ladite zone à potentiel nul (3), et
où le dispositif comprend en outre un anneau conducteur (11) relié ou pouvant être relié à la deuxième partie (2b) de chaque carte radiale (1) au moyen d'éléments d'interconnexion.

2. Dispositif selon l'une ou plusieurs des revendications précédentes, où ladite première partie (2a) comprend en outre une ou plusieurs zones auxiliaires (4) à fonction de déflecteur de champ et/ou à fonction de détection de tension, s'étendant parallèlement à ladite zone à potentiel nul (3), ladite zone à potentiel nul (3) étant interposée entre lesdites zones auxiliaires (4) et lesdites pistes conductrices en spirale (6).

3. Dispositif selon l'une ou plusieurs des revendications précédentes, où ladite première partie (2a) comprend en outre au moins une zone supplémentaire (5), configurée pour définir un couplage capacitif avec ledit conducteur électrique (E), ladite zone à potentiel nul (3) étant interposée entre ladite zone supplémentaire (5) et lesdites pistes conductrices en spirale (6).

4. Dispositif selon les revendications 2 et 3, où ladite zone supplémentaire (5) est alignée et interposée entre deux desdites zones auxiliaires (4).

5. Dispositif selon l'une ou plusieurs des revendications 2 à 4, où lesdites voies de connexion (8) sont également réparties de manière appropriée entre lesdites une ou plusieurs zones auxiliaires (4) et/ou ladite zone supplémentaire (5).

6. Dispositif selon l'une ou plusieurs des revendications précédentes, comprenant un capteur de température agencé dans ladite zone d'ombre définie par la zone à potentiel nul (3).

7. Dispositif selon l'une ou plusieurs des revendications précédentes, où ladite deuxième partie (2b) comporte un évidement de montage (7), agencé entre lesdites pistes conductrices en spirale (6).

8. Dispositif selon la revendication 7, où chaque couche conductrice (1a) comprend des pistes conductrices radiales se référant à des bornes agencées près d'un bord périphérique de la deuxième partie (2b).

9. Dispositif selon l'une ou plusieurs des revendications précédentes, où ledit anneau conducteur (11) comprend une zone à potentiel nul définie le long d'une extension circonférentielle dudit anneau conducteur (11).

10. Dispositif (10) selon l'une ou plusieurs des revendications précédentes, où ledit anneau conducteur (11) est réalisé au moyen d'une structure multicouche comprenant une ou plusieurs couches internes (11a) pourvues de pistes de connexion (11b) et deux couches externes (11c) se référant au potentiel zéro.

11. Dispositif (10) selon la revendication 10, où les couches externes (11c) intègrent une cage de Faraday renfermant les couches internes (11a).

12. Dispositif (10) selon la revendication 10 ou 11, où la structure multicouche de l'anneau conducteur (11) est traversée par des voies conductrices (11d) réparties selon des cercles concentriques, respectivement le long d'un bord radialement intérieur et d'un bord radialement extérieur de l'anneau conducteur (11).

13. Appareil (20) pour applications électrotechniques dans le domaine des tensions moyennes et élevées, comprenant un corps principal (21) en matériau électriquement isolant, un conducteur électrique (E) au moins partiellement intégré dans le corps principal et s'étendant le long d'un axe d'extension (A) de celui-ci, un dispositif (10) selon l'une ou plusieurs des revendications précédentes, intégré dans le corps principal (21) et agencé autour dudit conducteur électrique (E), et un connecteur (22) pour relier ledit dispositif (10) à une borne de commande.

14. Procédé de fabrication d'un appareil (20) selon la revendication 13, comprenant les étapes suivantes :
- fournir un conducteur électrique (E) ;
- fournir un dispositif (10) selon l'une ou plusieurs des revendications 1 à 12 ;
- agencer ledit conducteur électrique (E) à l'intérieur dudit dispositif (10) ;
- intégrer ledit dispositif (10) et au moins une partie dudit conducteur électrique (E) dans un matériau isolant.

15. Procédé selon la revendication 14, où l'intégration dans un matériau isolant comprend :
- fournir un moule définissant au moins une cavité de moulage en contre-forme par rapport au corps principal ;
- placer le conducteur électrique et le dispositif à l'intérieur du moule ;
- fixer le dispositif à l'intérieur de la cavité de moulage au niveau des inserts d'ancrage (23) portés par l'anneau conducteur (11) ;
- injecter le matériau isolant par au moins un orifice d'injection du matériau isolant, débouchant dans la cavité de moulage selon une direction sensiblement parallèle à l'axe d'extension (A) du conducteur (E).
